(19) Europäisches Patentamt
European Patent Office
Office européen des brevets

(11) EP 2 364 851 B1

(12) **EUROPEAN PATENT SPECIFICATION**

(45) Date of publication and mention of the grant of the patent:
**06.03.2013 Bulletin 2013/10**

(51) Int Cl.:
***B41J 2/14*** *(2006.01)* ***B41J 2/16*** *(2006.01)*

(21) Application number: **11157439.8**

(22) Date of filing: **09.03.2011**

# (54) Liquid ejecting head, liquid ejecting apparatus, and piezoelectric element

Flüssigkeitsausgabekopf, Flüssigkeitsausgabevorrichtung und piezoelektrisches Element

Tête d'éjection de liquide, appareil d'éjection de liquide et élément piézoélectrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.03.2010 JP 2010056804**
**28.05.2010 JP 2010122798**

(43) Date of publication of application:
**14.09.2011 Bulletin 2011/37**

(73) Proprietor: **Seiko Epson Corporation**
**Tokyo 163-0811 (JP)**

(72) Inventors:
- **Yonemura, Takayuki**
**Nagano 392-8502 (JP)**
- **Kitada, Kazuya**
**Nagano 392-8502 (JP)**

(74) Representative: **HOFFMANN EITLE**
**Patent- und Rechtsanwälte**
**Arabellastrasse 4**
**81925 München (DE)**

(56) References cited:
**EP-A2- 2 145 975** **US-A- 5 350 721**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### BACKGROUND

1. Technical Field

The present invention relates to (i) a piezoelectric element; (ii) a liquid ejecting head including a piezoelectric element that causes a change in the pressure in a pressure-generating chamber communicating with a nozzle opening and that includes a piezoelectric layer and electrodes configured to apply a voltage to the piezoelectric layer; and (iii) a liquid ejecting apparatus including the liquid ejecting head.

2. Related Art

A known piezoelectric element has a structure in which a piezoelectric layer composed of a piezoelectric material having an electromechanical conversion function, for example, a crystallized dielectric material is sandwiched between two electrodes. Such a piezoelectric element is mounted on a liquid ejecting head as an actuator device of a flexural oscillation mode, for example. A typical example of the liquid ejecting head is an ink jet recording head in which a part of a pressure-generating chamber communicating with a nozzle opening that ejects ink droplets is made up of a diaphragm which is deformed using a piezoelectric element to apply a pressure to ink in the pressure-generating chamber, thereby ejecting the ink as ink droplets from the nozzle opening.

A high piezoelectricity is required for piezoelectric materials used as a piezoelectric layer (piezoelectric ceramic) constituting such a piezoelectric element. A typical example of the piezoelectric materials is lead zirconate titanate (PZT) (refer to JP-A-2001-223404).

However, from the standpoint of environmental friendliness, there is a requirement for a piezoelectric material having a reduced content of lead. An example of a lead-free piezoelectric material is $BiFeO_3$, which has a perovskite structure represented by $ABO_3$. However, such $BiFeO_3$-based piezoelectric materials containing bismuth (Bi) and iron (Fe) have low relative dielectric constants $\varepsilon r$, and thus have the problem that the piezoelectricity (amount of strain) is low. This problem occurs not only in an ink jet recording head that ejects ink but also in other liquid ejecting heads that discharge droplets of a liquid other than ink.

EP 2 145 975 shows a piezoelectric device wherein the piezoelectric layer comprises a compound oxide which is a solid solution comprising bismuth niobium ferrate manganate and barium titanate.

### SUMMARY

One object of the invention is to provide a piezoelectric element which has a high relative dielectric constant and in which the burden on the environment is reduced, and to also provide a liquid ejecting head comprising said element and a liquid ejecting apparatus including the liquid ejecting head.

According to a first aspect of the invention, we provide a piezoelectric element comprising:

> a piezoelectric layer; and
> an electrode provided on the piezoelectric layer,
> wherein the piezoelectric layer comprises a compound oxide which is a solid solution comprising bismuth lanthanum ferrate manganate and barium titanate, wherein the molar ratio of the barium titanate to the total amount of the bismuth lanthanum ferrate manganate and the barium titanate is in the range 0.09 to 0.29. According to the first aspect of the invention, a piezoelectric material composed of a compound oxide having the perovskite structure and containing bismuth lanthanum ferrate manganate and barium titanate is used as a piezoelectric layer. Consequently, the relative dielectric constant can be increased. Furthermore, since the content of lead can be reduced, the burden on the environment can be reduced.

The molar ratio La/Bi of lanthanum to bismuth in the bismuth lanthanum ferrate manganate is preferably in the range 0.11 to 0.67. In this range, the relative dielectric constant of the piezoelectric layer is particularly high.

According to a second aspect of the invention, we provide a liquid ejecting head comprising a piezoelectric element according to the first aspect of the invention. According to the second aspect of the invention, since the liquid ejecting head includes a piezoelectric layer having a high relative dielectric constant, a liquid ejecting head having good ejection characteristics (displacement characteristics) can be provided. In addition, it is possible to provide a liquid ejecting head in which the content of lead is reduced, and thus the burden on the environment is reduced.

According to a third aspect of the invention, we provide a liquid ejecting apparatus comprising the ejection head according to the second aspect of the invention. According to the third aspect of the invention, since a piezoelectric material composed of a compound oxide having the perovskite structure and containing bismuth lanthanum ferrate manganate and barium titanate is used as the piezoelectric layer, the relative dielectric constant can be increased. Furthermore, since the content of lead can be reduced, the burden on the environment can be reduced.

## BRIEF DESCRIPTION OF THE DRAWINGS

The invention will be described with reference to the accompanying drawings, wherein like numbers reference like elements.

Fig. 1 is an exploded perspective view showing a schematic structure of a recording head according to a first embodiment.

Fig. 2 is a plan view of the recording head according to the first embodiment.

Fig. 3 is a cross-sectional view of the recording head according to the first embodiment.

Fig. 4 is a graph showing a P-V curve of sample 2.

Fig. 5 is a graph showing a P-V curve of sample 11.

Fig. 6 is a graph showing a P-V curve of sample 14.

Fig. 7 is a graph showing a P-V curve of sample 15.

Fig. 8 is a graph showing X-ray diffraction patterns.

Fig. 9 is an enlarged graph of the relevant part of the X-ray diffraction patterns.

Figs. 10A and 10B are cross-sectional views showing steps of producing the recording head according to the first embodiment.

Figs. 11A to 11C are cross-sectional views showing steps of producing the recording head according to the first embodiment.

Figs. 12A and 12B are cross-sectional views showing steps of producing the recording head according to the first embodiment.

Figs. 13A to 13C are cross-sectional views showing steps of producing the recording head according to the first embodiment.

Figs. 14A and 14B are cross-sectional views showing steps of producing the recording head according to the first embodiment.

Fig. 15 is a graph showing an X-ray diffraction pattern of Example 1.

Figs. 16A to 16F are graphs showing P-E curves of Comparative Example 1 and Examples 1 to 5, respectively.

Figs. 17A to 17E are graphs showing P-E curves of Example 1 and Examples 6 to 9.

Fig. 18 is a relative dielectric constant-composition plot of Examples 1 to 4 and Comparative Example 1.

Fig. 19 is a relative dielectric constant-composition plot of Example 1 and Examples 6 to 8.

Fig. 20 is a view showing a schematic structure of a recording apparatus according to an embodiment of the invention.

## DESCRIPTION OF EXEMPLARY EMBODIMENTS

Fig. 1 is an exploded perspective view showing a schematic structure of an ink jet recording head which is an example of a liquid electing head according to a first embodiment of the invention. Fig. 2 is a plan view of Fig. 1, and Fig. 3 is a cross-sectional view taken along line III-III in Fig. 2. As shown in Figs. 1 to 3, a channel-forming substrate 10 of this embodiment is formed of a single-crystal silicon substrate, and an elastic film 50 composed of silicon dioxide is provided on one surface of the channel-forming substrate 10.

A plurality of pressure-generating chambers 12 are arranged in the channel-forming substrate 10 in the width direction of the channel-forming substrate 10. A communication section 13 is provided in an outside area of the longitudinal direction of the pressure-generating chambers 12 of the channel-forming substrate 10. The communication section 13 communicates with each of the pressure-generating chambers 12 through an ink supply channel 14 and a communicating channel 15 which are provided for each pressure-generating chamber 12. The communication section 13 communicates with a reservoir section 31 of a protective substrate described below and forms a part of a reservoir functioning as an ink chamber common to the pressure-generating chambers 12. The ink supply channels 14 are formed so as to have a width smaller than the width of the pressure-generating chambers 12, and maintain a channel resistance of ink, which is supplied from the communication section 13 to the pressure-generating chambers 12, to be constant. In this embodiment, the ink supply channel 14 is formed by reducing the width of a channel at one side. Alternatively, the ink supply channel 14 may be formed by reducing the width of a channel at both sides. Alternatively, an ink supply channel may be formed not by reducing the width of a channel but by reducing a dimension in the thickness direction. In this embodiment, the channel-forming substrate 10 includes a liquid channel composed of the pressure-generating chambers 12, the communication section 13, the ink supply channels 14, and the communicating channels 15.

A nozzle plate 20 is fixed on the opening surface side of the channel-forming substrate 10 with an adhesive, a heat-adhesive film, or the like therebetween. The nozzle plate 20 includes nozzle openings 21 each of which communicates with an end portion of the corresponding pressure-generating chamber 12, the end portion being located opposite the ink supply channel 14. The nozzle plate 20 is composed of, for example, a glass-ceramic material, a single-crystal silicon substrate, or a stainless steel.

The elastic film 50 is provided on a side opposite the opening surface of the channel-forming substrate 10, as described above. An adhesion layer 56 for improving the adhesiveness between a first electrode 60 and an underlayer of the first electrode 60, e.g., the elastic film 50, the adhesion layer 56 being composed of, for example, titanium oxide and having a thickness of, for example, about 30 to 50 nm, is provided on the elastic film 50. An insulating film composed of, for example, zirconium oxide may be provided on the elastic film 50 according to need.

Furthermore, the first electrode 60, a piezoelectric layer 70 which is a thin film having a thickness of 2 μm or less, preferably in the range of 1 to 0.3 μm, and a second electrode 80 are stacked on the adhesion layer 56 to form a piezoelectric element 300. Herein, the piezoelectric element 300 refers to a portion including the first electrode 60, the piezoelectric layer 70, and the second electrode 80. In general, the piezoelectric element 300 is constituted by forming one of the electrodes of the piezoelectric element 300 as a common electrode, and patterning the other electrode and the piezoelectric layer 70 for each of the pressure-generating chambers 12. In this embodiment, the first electrode 60 is used as the common electrode of the piezoelectric element 300, and the second electrode 80 is used as an individual electrode of the piezoelectric element 300. However, these electrodes may be reversed on the grounds of a driving circuit or wiring. Furthermore, herein, a combination of the piezoelectric element 300 and a diaphragm in which a displacement is generated by the driving of the piezoelectric element 300 is referred to as "actuator device". In the example described above, the elastic film 50, the adhesion layer 56, the first electrode 60, and the insulating film which is provided according to need function as the diaphragm. However, the structure is not limited thereto. For example, the elastic film 50 and the adhesion layer 56 may not be provided. Alternatively, the piezoelectric element 300 itself may also substantially function as the diaphragm.

In the invention, the piezoelectric material constituting the piezoelectric layer 70 comprises a compound oxide having the perovskite structure which is a solid solution comprising bismuth lanthanum ferrate manganate and barium titanate. Preferably, the piezoelectric layer comprises at least 90 wt.% of the complex oxide, more preferably at least 95 wt.% or at least 99 wt.%. Most preferably, the layer consists of the afore-mentioned complex oxide. Preferably, bismuth lanthanum ferrate manganate and barium titanate together make up at least 90 mol%, preferably at least 95 mol% and even more preferably at least 99 mol% of the compound oxide. Most preferably, the complex oxide consists of bismuth lanthanum ferrate manganate and barium titanate. In the A-site of the perovskite structure, i.e., the $ABO_3$ structure, oxygen is 12-coordinated, and in the B-site thereof, oxygen is 6-coordinated to form an octahedron. Bismuth (Bi), lanthanum (La), and barium (Ba) are located in the A-site, and iron (Fe), manganese (Mn), and titanium (Ti) are located in the B-site. Specifically, the compound oxide having the perovskite structure is a solid solution in which bismuth lanthanum ferrate manganate and barium titanate are uniformly solid-soluted.

Furthermore, according to the invention, in the compound oxide having the perovskite structure and comprising bismuth lanthanum ferrate manganate and barium titanate, the molar ratio of the barium titanate to the total amount of the bismuth lanthanum ferrate manganate and the barium titanate is in the range 0.09 to 0.29. In the bismuth lanthanum ferrate manganate, the molar ratio La/Bi of lanthanum to bismuth is preferably in the range 0.11 to 0.67.

The compound oxide having the perovskite structure and comprising bismuth lanthanum ferrate manganate and barium titanate preferably has a composition ratio represented by, for example, general formula (1) below. The expression of general formula (1) is a composition notation based on the stoichiometry, and an inevitable shift of the composition due to a lattice mismatch, oxygen deficiency, or the like is permitted.

$$(1-x)\{(Bi_{1-a}, La_a)(Fe_{1-b}, Mn_b)O_3\}x\{BaTiO_3\} \quad (1)$$

$$(0.09 \leq x \leq 0.29,\ 0.10 \leq a \leq 0.39,\ 0.01 \leq b \leq 0.09)$$

In formula 1, x is preferably in the range 0.09-0.23, more preferably in the range 0.13-0.20. The index a is preferably in the range 0.10-0.29

When the piezoelectric material constituting the piezoelectric layer 70 is a compound oxide having the perovskite structure and containing bismuth lanthanum ferrate manganate and barium titanate, and the molar ratio of barium titanate to the total amount of bismuth lanthanum ferrate manganate and barium titanate is in the range 0.09 to 0.29, as described in Examples below, the relative dielectric constant can be increased, as compared with materials to which barium titanate is not added, that is, $BiFeO_3$-based piezoelectric materials which contain Bi, La, Fe and Mn.

Here, bismuth lanthanum ferrate manganate having the perovskite structure, which is a main component of the piezoelectric layer 70, will be described in detail. Bismuth lanthanum ferrate manganate having the perovskite structure is a compound oxide having the perovskite structure and containing Bi, La, Fe, and Mn, in which Bi and La are located in the A-site and Fe and Mn are located in the B-site described above. In addition, bismuth lanthanum ferrate manganate may have a composition ratio represented by general formula (2) below. Note that compound oxides having the perovskite structure and containing Bi, La, Fe, and Mn showed different characteristics of a ferroelectric material, an antiferroelectric material, and a paraelectric material depending on the composition ratio of the compound oxide. Piezoelectric elements (samples 1 to 18) in which the composition ratio of general formula (2) below was varied were prepared, and the relationship between the amount of polarization (P) and the voltage (V) was determined by applying a triangular wave of 25 V or 30 V. As examples of the results, the result of sample 2 is shown in Fig. 4, the result of sample 11 is shown in Fig. 5, the result of sample 14 is shown in Fig. 6, and the result of sample 15 is shown in Fig. 7. The compositions are shown in Table 1. In samples 16 to 18, the leak was too large to perform the measurement. Thus, samples 16 to 18 could not be used as piezoelectric materials.

$$(Bi_{1-m}, La_m) (Fe_{1-n}, Mn_n) O_3 \quad (2)$$

$$(0.10 \leq m \leq 0.38,\ 0.01 \leq n \leq 0.09)$$

As shown in Figs. 4 and 5, in each of samples 2 and 11, a hysteresis loop shape, which is characteristic to a ferroelectric material, was observed. A similar hysteresis was observed in each of sample 1 and samples 3 to 10. On the other hand, in sample 14, a double hysteresis having two hysteresis loop shapes in a positive electric field direction and a negative electric field direction, which is characteristic to an antiferroelectric material was observed as shown in Fig. 6. In samples 12 and 13, a similar double hysteresis was observed. Sample 15 was a paraelectric material, as shown in Fig. 7.

As shown in the X-ray diffraction patterns (Figs. 8 and 9) which are graphs showing the correlation between the diffraction intensity and the diffraction angle 2θ, when powder X-ray diffraction was measured, a diffraction peak attributable to a phase exhibiting ferroelectricity (ferroelectric phase) was observed in sample 4, and a diffraction peak attributable to a phase exhibiting antiferroelectricity (antiferroelectric phase) was observed in sample 14. In sample 11, both the peaks were observed. According to these results, it became clear that sample 11 is in a phase boundary between the ferroelectric phase and the antiferroelectric phase (morphotropic phase boundary (M.P.B.)). Fig. 9 is an enlarged graph of Fig. 8.

Table 1

| | m | n | Phase |
|---|---|---|---|
| Sample 1 | 0.10 | 0.03 | Ferroelectric |
| Sample 2 | 0.10 | 0.05 | Ferroelectric |
| Sample 3 | 0.10 | 0.09 | Ferroelectric |
| Sample 4 | 0.14 | 0.05 | Ferroelectric |
| Sample 5 | 0.17 | 0.03 | Ferroelectric |
| Sample 6 | 0.18 | 0.03 | Ferroelectric |
| Sample 7 | 0.20 | 0.01 | Ferroelectric |
| Sample 8 | 0.20 | 0.02 | Ferroelectric |
| Sample 9 | 0.19 | 0.03 | Ferroelectric |
| Sample 10 | 0.19 | 0.04 | Ferroelectric |
| Sample 11 | 0.19 | 0.05 | Ferroelectric |
| Sample 12 | 0.21 | 0.03 | Antiferroelectric |
| Sample 13 | 0.24 | 0.05 | Antiferroelectric |
| Sample 14 | 0.29 | 0.05 | Antiferroelectric |

(continued)

| | m | n | Phase |
|---|---|---|---|
| Sample 15 | 0.48 | 0.05 | Paraelectric |
| Sample 16 | 0.20 | 0.00 | - |
| Sample 17 | 0.10 | 0.00 | - |
| Sample 18 | 0.00 | 0.00 | - |

A lead electrode 90 extending from an end portion of the ink supply channel 14 side onto the elastic film 50 or the insulating film which is provided according to need, and composed of, for example, gold (Au) is connected to each second electrode 80 which is an individual electrode of the piezoelectric element 300.

A protective substrate 30 having the reservoir section 31 that constitutes at least a part of a reservoir 100 is bonded on the channel-forming substrate 10 on which the piezoelectric element 300 is formed, that is, above the first electrode 60 and on the elastic film 50 or the insulating film which is provided according to need and the lead electrode 90 with an adhesive 35. In this embodiment, this reservoir section 31 is formed so as to penetrate through the protective substrate 30 in the thickness direction of the protective substrate 30 and to extend in the width direction of the pressure-generating chambers 12. As described above, the reservoir section 31 communicates with the communication section 13 of the channel-forming substrate 10 to form the reservoir 100 functioning as an ink chamber common to the pressure-generating chambers 12. Alternatively, the communication section 13 of the channel-forming substrate 10 may be divided into a plurality of sections for each of the pressure-generating chambers 12 so that only the reservoir section 31 may constitute a reservoir. Furthermore, for example, only the pressure-generating chambers 12 may be provided in the channel-forming substrate 10, and the ink supply channels 14 communicating the reservoir 100 and the respective pressure-generating chambers 12 may be provided in a component (e.g., the elastic film 50, the insulating film which is provided according to need, and the like) interposed between the channel-forming substrate 10 and the protective substrate 30.

In addition, the protective substrate 30 has a piezoelectric element-holding section 32 that provides a space in which the movement of the piezoelectric elements 300 is not substantially disturbed, the piezoelectric element-holding section 32 being disposed in an area facing the piezoelectric elements 300. It is sufficient that the piezoelectric element-holding section 32 provides a space in which the movement of the piezoelectric elements 300 is not substantially disturbed. The space may be sealed or may not be sealed.

The protective substrate 30 is preferably composed of a material having a coefficient of thermal expansion substantially the same as that of the channel-forming substrate 10, for example, glass, a ceramic material, or the like. In this embodiment, the protective substrate 30 is formed of a single-crystal silicon substrate, which is the same material as the channel-forming substrate 10.

Furthermore, a through-hole 33 penetrating through the protective substrate 30 in the thickness direction is formed in the protective substrate 30. The end portion of the lead electrode 90 extending from each of the piezoelectric elements 300 is provided so as to be exposed in the through-hole 33.

A driving circuit 120 for driving the piezoelectric elements 300 arranged in parallel is fixed on the protective substrate 30. For example, a circuit substrate or a semiconductor integrated circuit (IC) can be used as the driving circuit 120. The driving circuit 120 is electrically connected to the lead electrode 90 with a connecting wire 121 therebetween, the connecting wire 121 being composed of an electrically conductive wire such as a bonding wire.

Furthermore, a compliance substrate 40 including a sealing film 41 and a fixing plate 42 is bonded on the protective substrate 30. The sealing film 41 is composed of a material having flexibility and a low rigidity. This sealing film 41 seals one surface of the reservoir section 31. The fixing plate 42 is composed of a relatively hard material. An area of the fixing plate 42 facing the reservoir 100 forms an opening 43 in which the fixing plate 42 is completely removed in the thickness direction thereof. Accordingly, the surface of the reservoir 100 is sealed by only the flexible sealing film 41.

In an ink jet recording head I of this embodiment, ink is introduced from an ink inlet connected to an external ink supply unit (not shown), and the inside of a space ranging from the reservoir 100 to the nozzle openings 21 is filled with the ink. Subsequently, a voltage is applied between the first electrode 60 and the second electrode 80 corresponding to each of the pressure-generating chambers 12 in accordance with a recording signal from the driving circuit 120 so that the elastic film 50, the adhesion layer 56, the first electrode 60, and the piezoelectric layer 70 are subjected to flexural deformation. As a result, the pressure in the respective pressure-generating chambers 12 increases to eject ink droplets from the nozzle openings 21.

Next, an example of a method for producing the ink jet recording head of this embodiment will be described with reference to Figs. 10A to 14B. Figs. 10A to 14B are each a cross-sectional view of a pressure-generating chamber in the longitudinal direction.

First, as shown in Fig. 10A, a silicon dioxide film composed of silicon dioxide ($SiO_2$) constituting an elastic film 50 and the like is formed on a surface of a wafer 110 for a channel-forming substrate, which is a silicon wafer, by thermal oxidation or the like. Next, as shown in Fig. 10B, an adhesion layer 56 composed of, for example, titanium oxide is formed on the elastic film 50 (silicon dioxide film) by a reactive sputtering method, thermal oxidation, or the like.

Next, as shown in Fig. 11A, a first electrode 60 composed of, for example, platinum, iridium, iridium oxide, or a stacked structure thereof is formed over the entire surface of the adhesion layer 56 by a sputtering method or the like.

Next, a piezoelectric layer 70 is stacked on the first electrode 60. The method for forming the piezoelectric layer 70 is not particularly limited. For example, the piezoelectric layer 70 can be formed by using a metal-organic decomposition (MOD) method in which a piezoelectric layer 70 composed of a metal oxide is obtained by applying a solution prepared by dissolving or dispersing an organometallic compound in a solvent, drying the solution, and further performing baking at a high temperature, or a chemical solution method such as a sol-gel method. Other liquid-phase methods and solid-phase methods such as a laser ablation method, a sputtering method, a pulse laser deposition (PLD) method, a chemical vapor deposition (CVD) method, and an aerosol deposition method may also be employed.

A specific example of a procedure for forming the piezoelectric layer 70 will be described. First, as shown in Fig. 11B, a sol or an MOD solution (precursor solution) containing organometallic compounds, specifically, organometallic compounds containing Bi, Fe, La, Mn, Ti, and Ba in a ratio that achieves a desired composition ratio is applied onto the first electrode 60 by a spin-coating method or the like to form a piezoelectric precursor film 71 (coating step).

The precursor solution applied is prepared by mixing organometallic compounds containing Bi, Fe, La, Mn, Ti, or Ba so that respective metals satisfy a desired molar ratio, and dissolving or dispersing the resulting mixture in an organic solvent such as an alcohol. Examples of the organometallic compounds containing Bi, Fe, La, Mn, Ti, or Ba that can be used include metal alkoxides, organic acid salts, and β-diketone complexes. An example of the organometallic compound containing Bi is bismuth 2-ethylhexanoate. An example of the organometallic compound containing Fe is iron 2-ethylhexanoate. An example of the organometallic compound containing La is lanthanum 2-ethylhexanoate. An example of the organometallic compound containing Mn is manganese 2-ethylhexanoate. Examples of the organometallic compound containing Ti include titanium isopropoxide, titanium 2-ethylhexanoate, and titanium (di-i-propoxide)bis(acetylacetonate). Examples of the organometallic compound containing Ba include barium isopropoxide, barium 2-ethylhexanoate, and barium acetylacetonate.

Next, this piezoelectric precursor film 71 is heated to a certain temperature, and dried for a certain period of time (drying step). Next, the dried piezoelectric precursor film 71 is degreased by heating to a certain temperature and maintained for a certain period of time (degreasing step). Herein, the term "degreasing" means that an organic component contained in the piezoelectric precursor film 71 is removed as, for example, $NO_2$, $CO_2$, and $H_2O$. The atmospheres in the drying step and the degreasing step are not limited, and these steps may be performed in air or in an inert gas.

Next, as shown in Fig. 11C, the piezoelectric precursor film 71 is crystallized by heating to a certain temperature, for example, about 600°C to 700°C and maintaining for a certain period of time to form a piezoelectric film 72 (baking step). The atmosphere in this baking step is also not limited, and the baking step may be performed in air or in an inert gas.

Examples of a heating device used in the drying step, the degreasing step, and the baking step include a rapid thermal annealing (RTA) device with which heating is conducted by irradiation of an infrared lamp, and a hot plate.

Next, a resist (not shown) having a predetermined shape is formed on the piezoelectric film 72. As shown in Fig. 12A, for example, the first electrode 60 and a first layer of the piezoelectric film 72 are pattered at the same time using the resist as a mask so that side faces of the first electrode 60 and the first layer of the piezoelectric film 72 are slanted.

Next, after the resist is removed, the above-described coating step, drying step, and degreasing step or the above-described coating step, drying step, degreasing step, and baking step are repeated a plurality of times in accordance with a desired thickness or the like to form a piezoelectric layer 70 including a plurality of piezoelectric films 72. Thus, as shown in Fig. 12B, the piezoelectric layer 70 including a plurality of piezoelectric films 72 and having a certain thickness is formed. For example, when the film thickness of a coating solution per application is about 0.1 μm, for example, the thickness of the whole piezoelectric layer 70 including ten piezoelectric films 72 is about 1.1 μm. In this embodiment, a plurality of piezoelectric films 72 are stacked. Alternatively, only a single piezoelectric film 72 may be provided.

After the piezoelectric layer 70 is formed in this manner, as shown in Fig. 13A, a second electrode 80 composed of, for example, platinum is formed on the piezoelectric layer 70 by a sputtering method or the like. The piezoelectric layer 70 and the second electrode 80 are pattered at the same time in an area facing each pressure-generating chamber 12 to form a piezoelectric element 300 including the first electrode 60, the piezoelectric layer 70, and the second electrode 80. Note that the patterning of the piezoelectric layer 70 and the second electrode 80 can be performed at one time by dry etching through a resist (not shown) formed so as to have a predetermined shape. Post-annealing may then be performed in a temperature range of 600°C to 700°C as needed. As a result, satisfactory interfaces can be formed between the piezoelectric layer 70 and the first electrode 60 and between the piezoelectric layer 70 and the second electrode 80, and in addition, crystallinity of the piezoelectric layer 70 can be improved.

Next, as shown in Fig. 13B, a lead electrode 90 composed of, for example, gold (Au) is formed over the entire surface of the wafer 110 for a channel-forming substrate, and patterning is then performed for each piezoelectric element 300 through a mask pattern (not shown) composed of a resist or the like.

Next, as shown in Fig. 13C, a wafer 130 for a protective substrate, the wafer 130 being a silicon wafer and being formed into a plurality of protective substrates 30, is bonded to a surface of the wafer 110, the surface having the piezoelectric elements 300 thereon, with an adhesive 35 therebetween. Subsequently, the thickness of the wafer 110 is reduced to a certain value.

Next, as shown in Fig. 14A, a mask film 52 is formed on the wafer 110 for a channel-forming substrate, and is patterned so as to have a predetermined shape.

Next, as shown in Fig. 14B, anisotropic etching (wet etching) of the wafer 110 is performed using an alkaline solution such as a potassium hydroxide (KOH) solution through the mask film 52, thereby forming a pressure-generating chamber 12, a communication section 13, an ink supply channel 14, a communicating channel 15, etc. corresponding to each piezoelectric element 300.

Next, unnecessary portions of the outer peripheries of the wafer 110 for a channel-forming substrate and the wafer 130 for a protective substrate are removed by, for example, cutting by dicing or the like. The mask film 52 provided on a surface of the wafer 110, the surface being located opposite the wafer 130, is removed. A nozzle plate 20 in which nozzle openings 21 are formed is then bonded to the surface, and a compliance substrate 40 is bonded to the wafer 130. The wafer 110 and other components are then divided into a channel-forming substrate 10 etc. having a size of one chip, as shown in Fig. 1. Thus, the ink jet recording head I of this embodiment is produced.

## EXAMPLES

The invention will now be described more specifically by way of Examples. It should be noted that the invention is not limited to Examples below.

### Example 1

First, a silicon dioxide film having a thickness of 400 nm was formed on a surface of a silicon substrate oriented in the (100) direction by thermal oxidation. Next, a titanium film having a thickness of 40 nm was formed on the silicon dioxide film by an RF sputtering method. The titanium film was thermally oxidized to form a titanium oxide film. Next, a platinum film having a thickness of 150 nm was formed on the titanium oxide film in two stages of ion sputtering and a vapor deposition method, thus forming a first electrode oriented in the (111) direction.

Subsequently, a piezoelectric layer was formed on the first electrode by a spin coating method. The method for forming the piezoelectric layer was as follows. First, xylene and octane solutions of bismuth 2-ethylhexanoate, lanthanum 2-ethylhexanoate, iron 2-ethylhexanoate, manganese 2-ethylhexanoate, barium 2-ethylhexanoate, and titanium 2-ethylhexanoate were mixed in a certain ratio to prepare a precursor solution. This precursor solution was dropped on the substrate having the titanium oxide film and the first electrode thereon, and the substrate was rotated at 1,500 rpm to form a piezoelectric precursor film (coating step). Next, drying and degreasing were conducted at 350°C for three minutes (drying and degreasing steps). These coating step and drying and degreasing steps were repeated three times, and baking was then conducted at 650°C for three minutes by rapid thermal annealing (RTA). This step in which the coating step and the drying and degreasing steps were repeated three times and the baking step was then conducted at one time was repeated three times. Thus, a piezoelectric layer having a total thickness of 345 nm was formed by performing the coating total nine times.

Subsequently, a platinum film having a thickness of 100 nm was formed as a second electrode 80 on the piezoelectric layer 70 by a DC sputtering method, and baking was then conducted at 650°C for five minutes using RTA, thus forming a piezoelectric element 300 including the piezoelectric layer 70 composed of a compound oxide having the perovskite structure represented by general formula (1) above in which x was 0.09, a was 0.19, and b was 0.03. Examples 2 to 9

Piezoelectric elements 300 were formed as in Example 1 except that the mixing ratio of the xylene and octane solutions of bismuth 2-ethylhexanoate, lanthanum 2-ethylhexanoate, iron 2-ethylhexanoate, manganese 2-ethylhexanoate, barium 2-ethylhexanoate, and titanium 2-ethylhexanoate was changed, and compound oxides represented by general formula (1) above in which x, a, and b were those shown in Table 2 were used as the piezoelectric layer 70. Comparative Example 1

A piezoelectric elements 300 was formed as in Example 1 except that barium 2-ethylhexanoate and titanium 2-ethylhexanoate were not incorporated in the precursor solution, and a compound oxide represented by general formula (1) above in which x, a, and b were those shown in Table 2 was used as the piezoelectric layer 70.

Table 2

| | x | a | b |
|---|---|---|---|
| Example 1 | 0.09 | 0.19 | 0.03 |
| Example 2 | 0.13 | 0.19 | 0.03 |
| Example 3 | 0.17 | 0.19 | 0.03 |
| Example 4 | 0.23 | 0.19 | 0.03 |
| Example 5 | 0.29 | 0.19 | 0.03 |
| Example 6 | 0.09 | 0.10 | 0.03 |
| Example 7 | 0.09 | 0.15 | 0.03 |
| Example 8 | 0.09 | 0.29 | 0.03 |
| Example 9 | 0.09 | 0.39 | 0.03 |
| Comparative Example 1 | 0 | 0.19 | 0.03 |

Test Example 1

For each of the piezoelectric elements of Examples 1 to 9 and Comparative Example 1, a powder X-ray diffraction pattern of the piezoelectric layer was determined at room temperature with a D8 Discover X-ray diffractometer manufactured by Bruker AXS using CuKα-rays as an X-ray source. As a result, only peaks attributable to the $ABO_3$ structure and peaks attributable to the substrate were observed in all Examples 1 to 9 and Comparative Example 1, and no other peaks attributable to a heterogeneous phase was observed. As an example of the results, an X-ray diffraction pattern showing the correlation between the diffraction intensity and the diffraction angle 2θ of Example 1 is shown in Fig. 15.

Test Example 2

For each of the piezoelectric elements of Examples 1 to 9 and Comparative Example 1, the relationship between the amount of polarization and the electric field (P-E curve) at an applied electric field of 800 $kVcm^{-1}$ was determined by applying a triangular wave of a frequency of 1 kHz at room temperature with an FCF-1A ferroelectric characteristic evaluation system manufactured by TOYO Corporation using an electrode pattern having a diameter ϕ of 400 μm. The result of Comparative Example 1 is shown in Fig. 16A, the result of Example 1 is shown in Fig. 16B, the result of Example 2 is shown in Fig. 16C, the result of Example 3 is shown in Fig. 16D, the result of Example 4 is shown in Fig. 16E, and the result of Example 5 is shown in Fig. 16F. The result of Example 6 is shown in Fig. 17A, the result of Example 7 is shown in Fig. 17B, the result of Example 8 is shown in Fig. 17D, the result of Example 9 is shown in Fig. 17E, and the result of Example 1 is also shown in Fig. 17C.

According to the results, as shown in Figs. 16A to 17E, Examples 1 to 9 and Comparative Example 1 were ferroelectric materials. More specifically, as shown in Figs. 16A to 16F, when a was 0.19, in Comparative Example 1, the amount of polarization $P_r$ was 52 $\mu Ccm^{-2}$, whereas in each of Examples 2 to 5, the amount of polarization $P_r$ was in the range of 27 to 4 $\mu Ccm^{-2}$, which was smaller than that of Comparative Example 1. In addition, with an increase in x, the amount of polarization $P_r$ tended to decrease. When x was 0.29, a P-E loop close to that of a paraelectric material was obtained. According to these results, it became clear that the characteristics of a ferroelectric material were exhibited at least in the range of $0 \leq x \leq 0.29$. Furthermore, as shown in Figs. 17A to 17E, when x was 0.09, with an increase in a, the amount of polarization $P_r$ tended to decrease. When a was 0.39, the amount of polarization $P_r$ decreased and a P-E loop close to that of a paraelectric material was obtained. According to these results, it became clear that the characteristics of a Ferroelectric material were exhibited at least in the range of $0 \leq a \leq 0.39$.

Test Example 3

For each of the piezoelectric elements of Examples 1 to 9 and Comparative Example 1, the relative dielectric constant of the piezoelectric layer was measured with a 4294A impedance analyzer manufactured by Hewlett-Packard Development Company at room temperature (25°C) at a frequency of 1 kHz using an electrode pattern having a diameter ϕ of 500 μm. The results of Examples 1 to 4 and Comparative Example 1 are shown in Fig. 18. The results of Example 1 and Examples 6 to 8 are shown in Fig. 19.

According to the results, as shown in Fig. 18, when x was in the range of $0.05 \leq x \leq 0.23$, the piezoelectric layer showed a relative dielectric constant larger than that of Comparative Example 1. In addition, it was found that the maximum of the relative dielectric constant was present near x = 0.17. Similarly, as shown in Fig. 19, relative dielectric constants larger than that of Comparative Example 1 were shown in the range of $0.10 \leq a \leq 0.29$.

Other embodiments

Embodiments of the invention have been described, but the basic configuration of the invention is not limited to the configuration described above. For example, in the embodiments described above, a single-crystal silicon substrate was exemplified as the channel-forming substrate 10. However, the channel-forming substrate 10 is not particularly limited to this. Alternatively, for example, a silicon-on-insulator (SOI) substrate, or another material such as glass may also be used.
Furthermore, the piezoelectric element 300 in which the first electrode 60, the piezoelectric layer 70, and the second electrode 80 are sequentially stacked on the substrate (channel-forming substrate 10) has been exemplified in the embodiments described above. However, the piezoelectric element is not limited thereto. For example, the invention can also be applied to a longitudinal vibration piezoelectric element in which a piezoelectric material and an electrode-forming material are alternately stacked and the resulting stacked structure is expanded and contracted in the axial direction.
Furthermore, the ink jet recording head of these embodiments constitutes a part of a recording head unit including an ink channel communicating with an ink cartridge and the like, and is mounted on an ink jet recording apparatus. Fig. 20 is a schematic view showing an example of such an ink jet recording apparatus.
An ink jet recording apparatus II shown in Fig. 20 includes recording head units 1A and 1B each including the ink jet recording head I. Cartridges 2A and 2B constituting ink supply units are detachably provided in the recording head units 1A and 1B, respectively. A carriage 3 mounting the recording head units 1A and 1B is provided on a carriage shaft 5 attached to a main body 4 of the apparatus so as to move in a direction of the shaft. The recording head units 1A and 1B eject, for example, a black ink composition and a color ink composition, respectively.
When a driving force of a driving motor 6 is transmitted to the carriage 3 through a plurality of gears (not shown) and a timing belt 7, the carriage 3 mounting the recording head units 1A and 1B is moved along the carriage shaft 5. A platen 8 is provided along the carriage shaft 5 in the main body 4. A recording sheet S, such as paper, used as a recording medium and fed by a paper-feeding roller (not shown) or the like is transported while being put around the platen 8.
In the embodiments described above, an ink jet recording head has been described as an example of a liquid ejecting head. However, the invention is widely used in overall liquid ejecting heads and can also be applied to liquid ejecting heads that eject a liquid other than ink. Examples of the other liquid ejecting heads include recording heads used in an image-recording apparatus such as a printer, coloring-material-ejecting heads used in producing a color filter of a liquid crystal display or the like, electrode-material-ejecting heads used for forming an electrode of an organic EL display, a field emission display (FED), or the like, and living-organic-matter-ejecting heads used for producing a biochip.
Furthermore, the application of the invention is not limited to a piezoelectric element mounted on a liquid ejecting head typified by an ink jet recording head. The invention can also be applied to piezoelectric elements mounted on other devices such as an ultrasonic device, e.g., an ultrasonic generator; an ultrasonic motor; a pressure sensor; and a pyroelectric element such as an infrared (IR) sensor. Furthermore, the invention can also be similarly applied to ferroelectric elements such as a ferroelectric memory.

## Claims

**1.** A piezoelectric element comprising:

a piezoelectric layer (70); and
an electrode (80) provided on the piezoelectric layer,
wherein the piezoelectric layer comprises a compound oxide which is a solid solution comprising bismuth lanthanum ferrate manganate and barium titanate,
wherein the molar ratio of the barium titanate to the total amount of the bismuth lanthanum ferrate manganate and the barium titanate is in the range 0.09 to 0.29.

**2.** The piezoelectric element according to Claim 1,
wherein the molar ratio La/Bi of lanthanum to bismuth in the bismuth lanthanum ferrate manganate is in the range 0.11 to 0.67.

**3.** A piezoelectric element according to claim 1,

wherein the compound oxide has the following formula:

$$(1-x)\{(Bi_{1-a}, La_a)(Fe_{1-b}, Mn_b)O_3\}x\{BaTiO_3\} \cdots (1)$$

$$(0.09 \leq x \leq 0.29,\ 0.10 \leq a \leq 0.39,\ 0.01 \leq b \leq 0.09)$$

**4.** A liquid ejecting head comprising:

a pressure-generating chamber communicating with a nozzle opening; and
a piezoelectric element as defined in any of claims 1 to 3.

**5.** A liquid ejecting apparatus comprising:

the liquid ejecting head according to Claim 4.

**Patentansprüche**

**1.** Piezoelektrisches Element, umfassend:

eine piezoelektrische Schicht (70); und
eine Elektrode (80), die auf der piezoelektrischen Schicht bereitgestellt wird,
wobei die piezoelektrische Schicht eine Oxidverbindung umfasst, die eine feste Lösung ist, umfassend Wismut-Lanthan-Ferrat-Manganat und Barium-Titanat,
wobei das Molverhältnis des Barium-Titanats zur Gesamtmenge des Wismut-Lanthan-Ferrat-Manganats und des Barium-Titanats im Bereich von 0,09 bis 0,29 liegt.

**2.** Piezoelektrisches Element gemäß Anspruch 1, wobei das Molverhältnis La/Bi des Lanthans zum Wismut in dem Wismut-Lanthan-Ferrat-Manganat im Bereich von 0,11 bis 0,67 liegt.

**3.** Piezoelektrisches Element gemäß Anspruch 1, wobei die Oxidverbindung die folgende Formel besitzt:

$$(1-x)\{(Bi_{1-a}, La_a)(Fe_{1-b}, Mn_b)O_3\}x\{BaTiO_3\} \quad \ldots(1)$$

$$(0{,}09 \leq x \leq 0{,}29,\ 0{,}10 \leq a \leq 0{,}39,\ 0{,}01 \leq b \leq 0{,}09).$$

**4.** Flüssigkeitsausstoßkopf, umfassend:

eine druckerzeugende Kammer, die mit einer Düsenöffnung kommuniziert; und
ein piezoelektrisches Element, wie es in einem der Ansprüche 1 bis 3 definiert wird.

**5.** Flüssigkeitsausstoßvorrichtung, umfassend:

den Flüssigkeitsausstoßkopf gemäß Anspruch 4.

**Revendications**

**1.** Elément piézoélectrique comprenant :

une couche piézoélectrique (70) ; et
une électrode (80) pourvue sur la couche piézoélectrique,
où la couche piézoélectrique comprend un oxyde composé qui est une solution solide comprenant du manganate-ferrate-lanthane-bismuth et du titanate de baryum,
où le rapport molaire du titane de baryum sur la quantité totale du manganate-ferrate-lanthane-bismuth et du titanate de baryum se trouve dans la plage allant de 0,09 à 0,29.

**2.** Elément piézoélectrique selon la revendication 1, dans lequel le rapport molaire La/Bi de lanthane sur bismuth dans le manganate-ferrate-lanthane-bismuth se trouve dans la plage allant de 0,11 à 0,67.

**3.** Elément piézoélectrique selon la revendication 1, dans lequel l'oxyde composé possède la formule suivante :

$$(1-x)\{(Bi_{1-a}, La_a)(Fe_{1-b}, Mn_b)O_3\}\ x\ \{BaTiO_3\} \ldots (1)$$

$$(0,09 \leq x \leq 0,29,\ 0,10 \leq a \leq 0,39,\ 0,01 \leq b \leq 0,09)$$

**4.** Tête d'éjection de liquide comprenant :

une chambre de génération de pression communiquant avec une ouverture de buse ; et
un élément piézoélectrique tel que défini dans l'une des revendications 1 à 3.

**5.** Appareil d'éjection de liquide comprenant :

la tête d'éjection de liquide selon la revendication 4.

FIG. 1

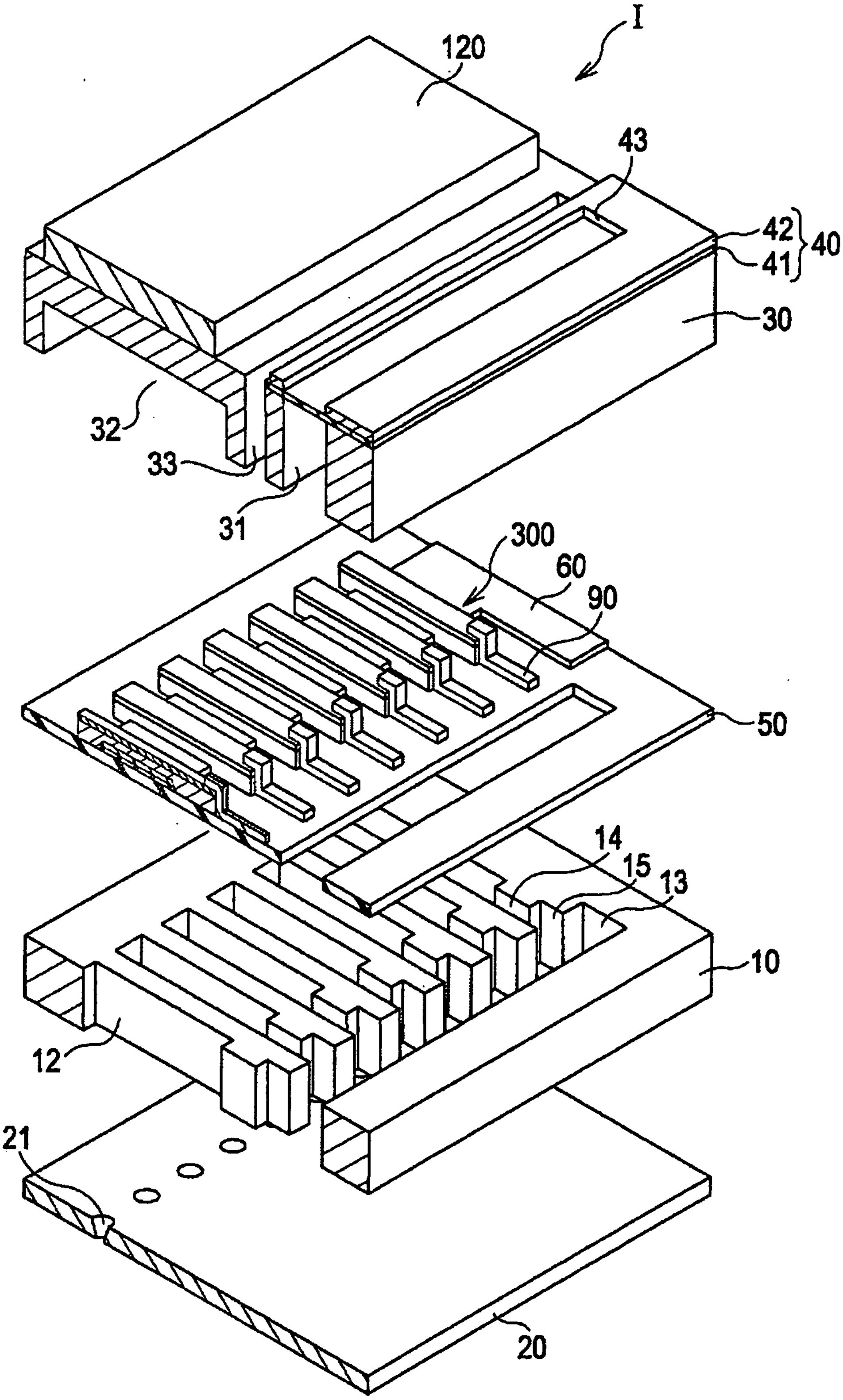

FIG. 2

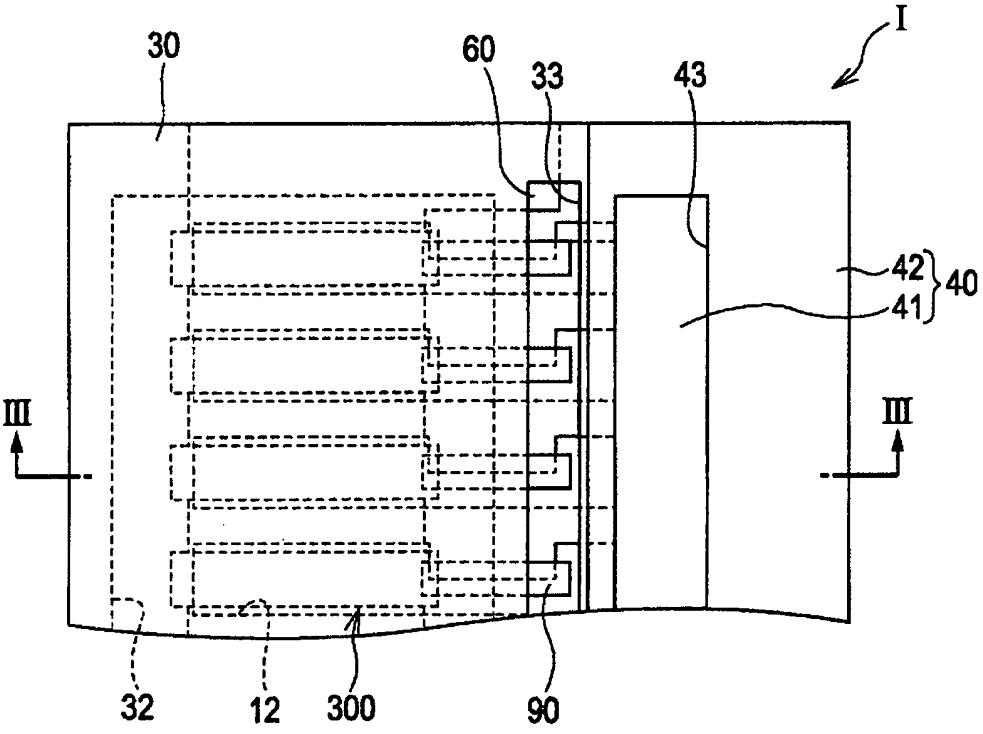

I
30
60
33
43
42
41
40
III
III
32
12
300
90


FIG. 3

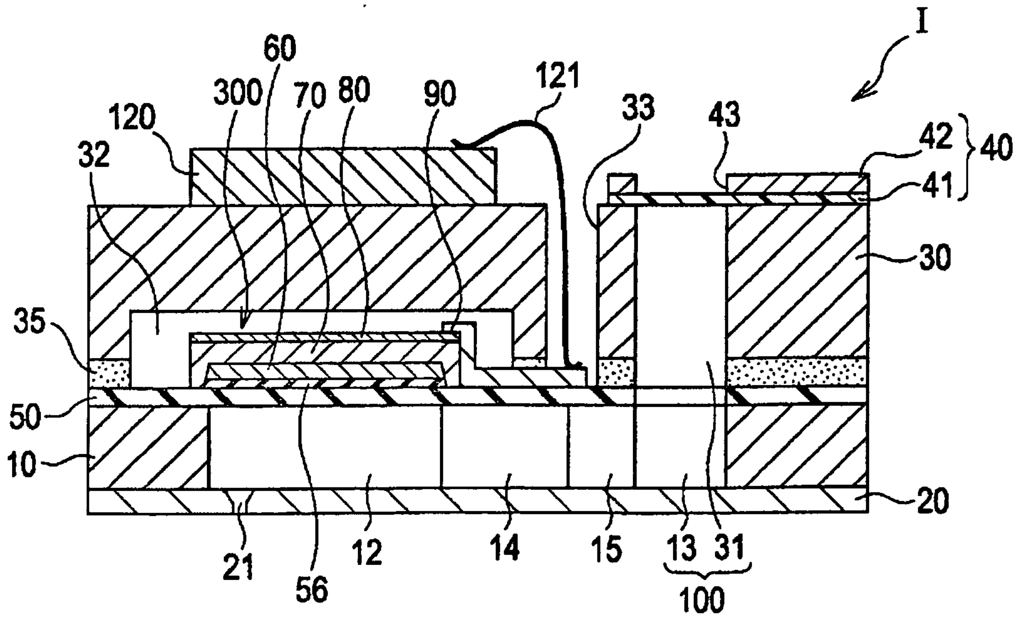

I
60
300
70
80
90
121
120
32
33
43
42
41
40
35
30
50
10
20
21
12
14
15
13
31
56
100

FIG. 4

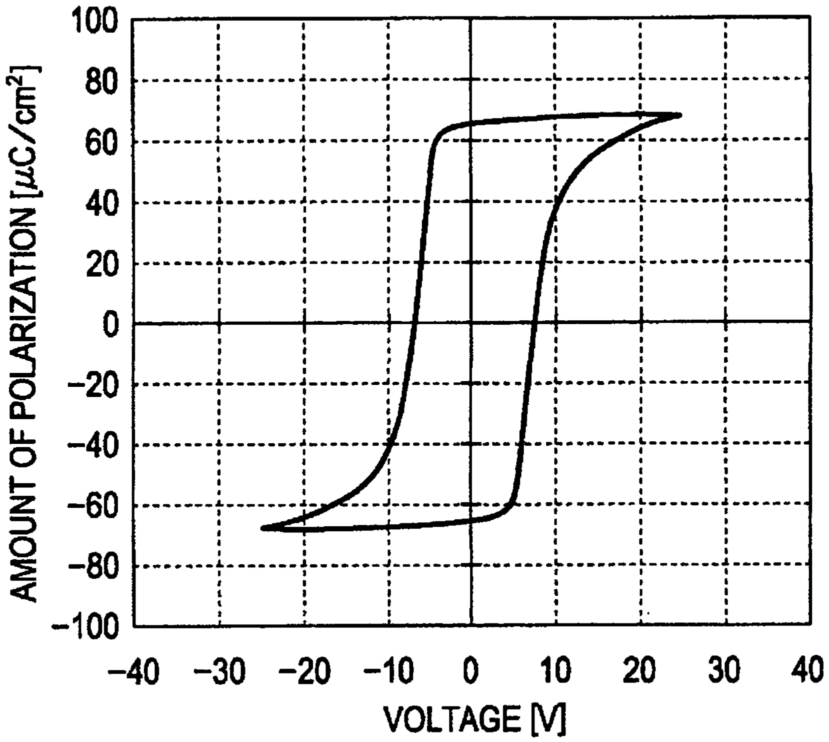
AMOUNT OF POLARIZATION [μC/cm²]
100
80
60
40
20
0
−20
−40
−60
−80
−100
−40
−30
−20
−10
0
10
20
30
40
VOLTAGE [V]

FIG. 5

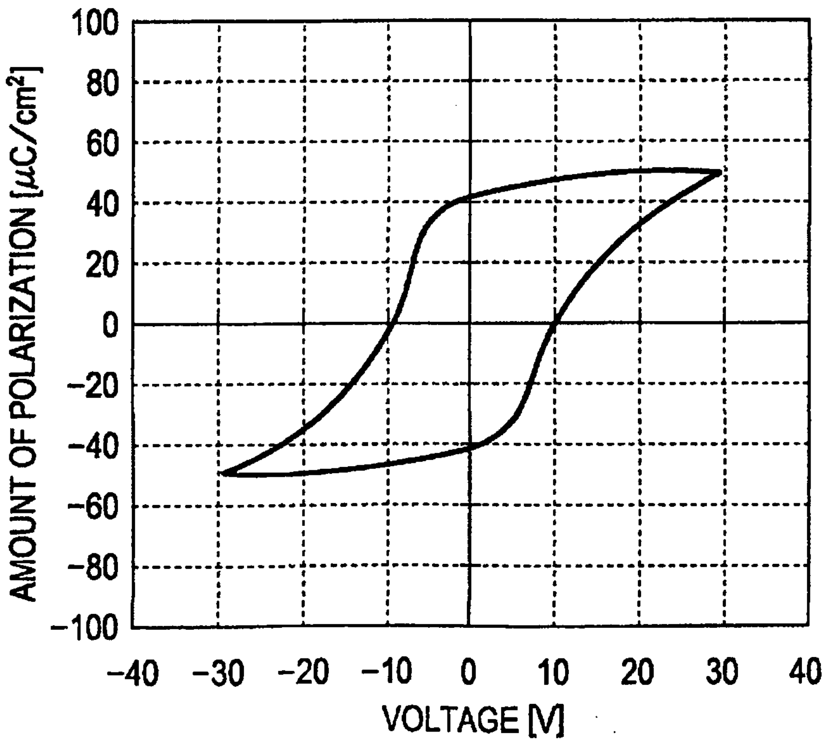
AMOUNT OF POLARIZATION [μC/cm²]
100
80
60
40
20
0
−20
−40
−60
−80
−100
−40
−30
−20
−10
0
10
20
30
40
VOLTAGE [V]

FIG. 6

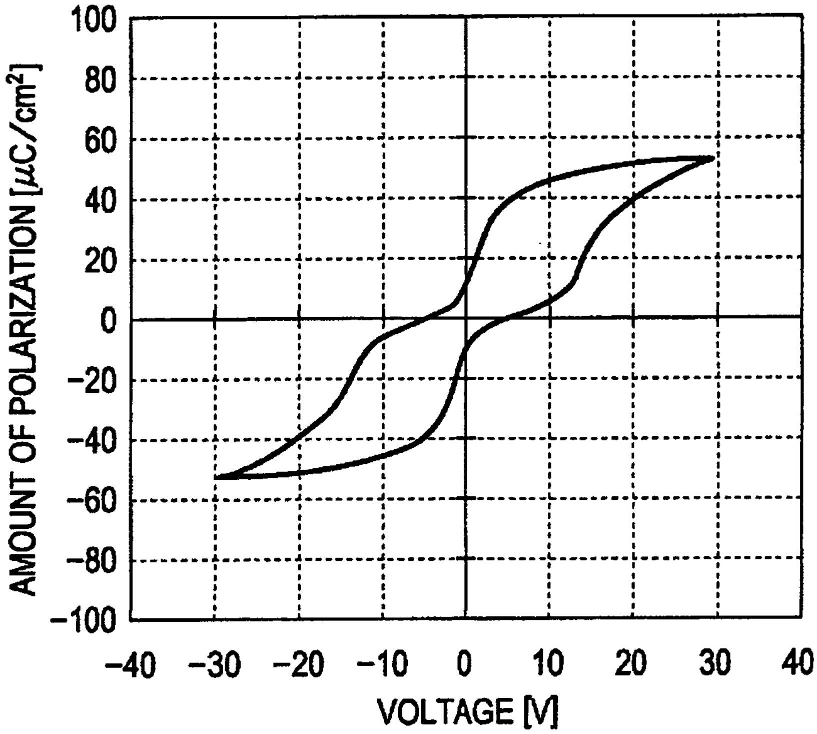
AMOUNT OF POLARIZATION [μC/cm²]
100
80
60
40
20
0
−20
−40
−60
−80
−100
−40
−30
−20
−10
0
10
20
30
40
VOLTAGE [V]

FIG. 7

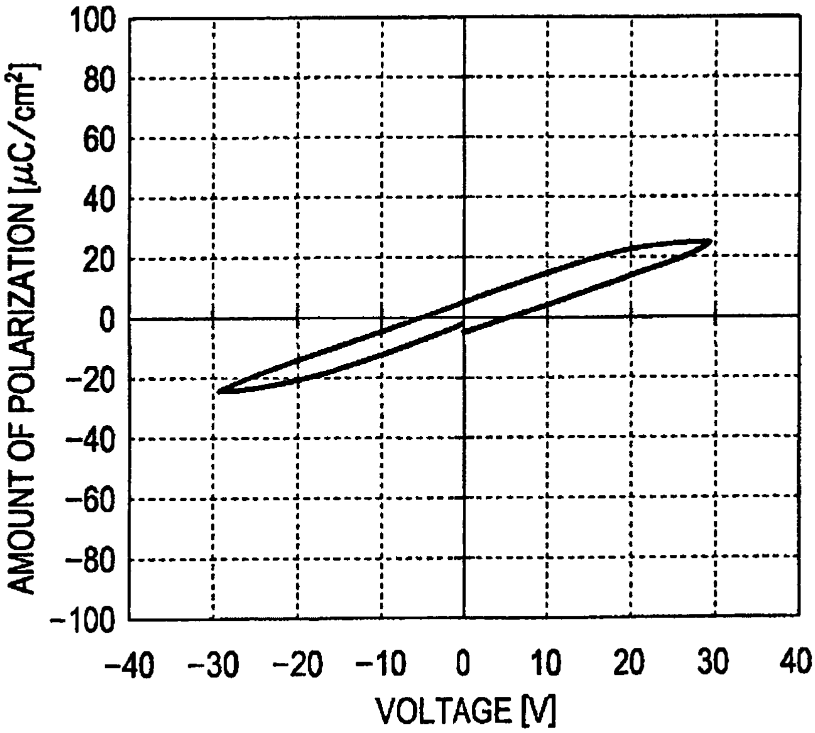
AMOUNT OF POLARIZATION [μC/cm²]
100
80
60
40
20
0
−20
−40
−60
−80
−100
−40
−30
−20
−10
0
10
20
30
40
VOLTAGE [V]

FIG. 8

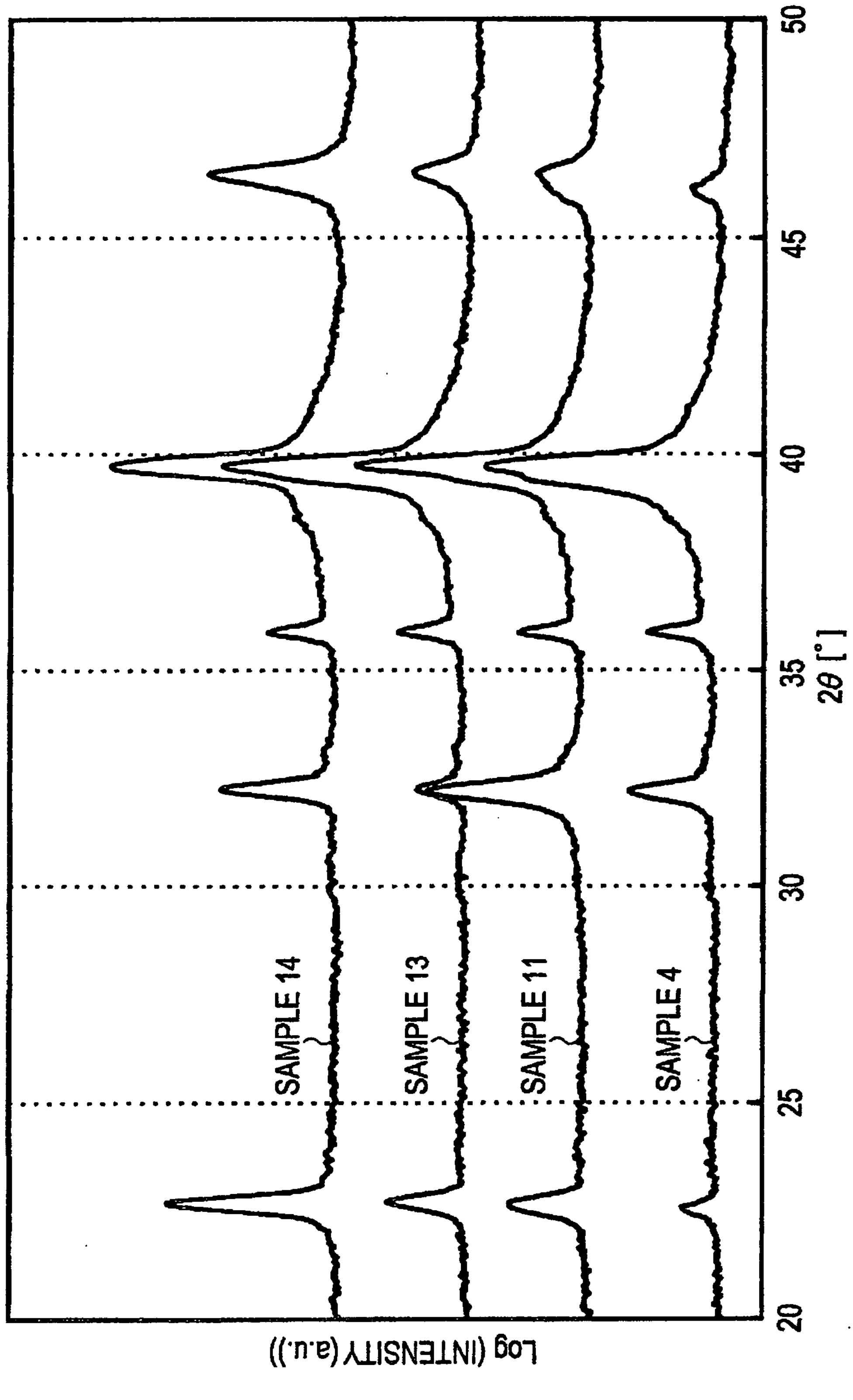
SAMPLE 14
SAMPLE 13
SAMPLE 11
SAMPLE 4
20
25
30
35
40
45
50
2θ [°]
Log (INTENSITY (a.u.))

FIG. 9

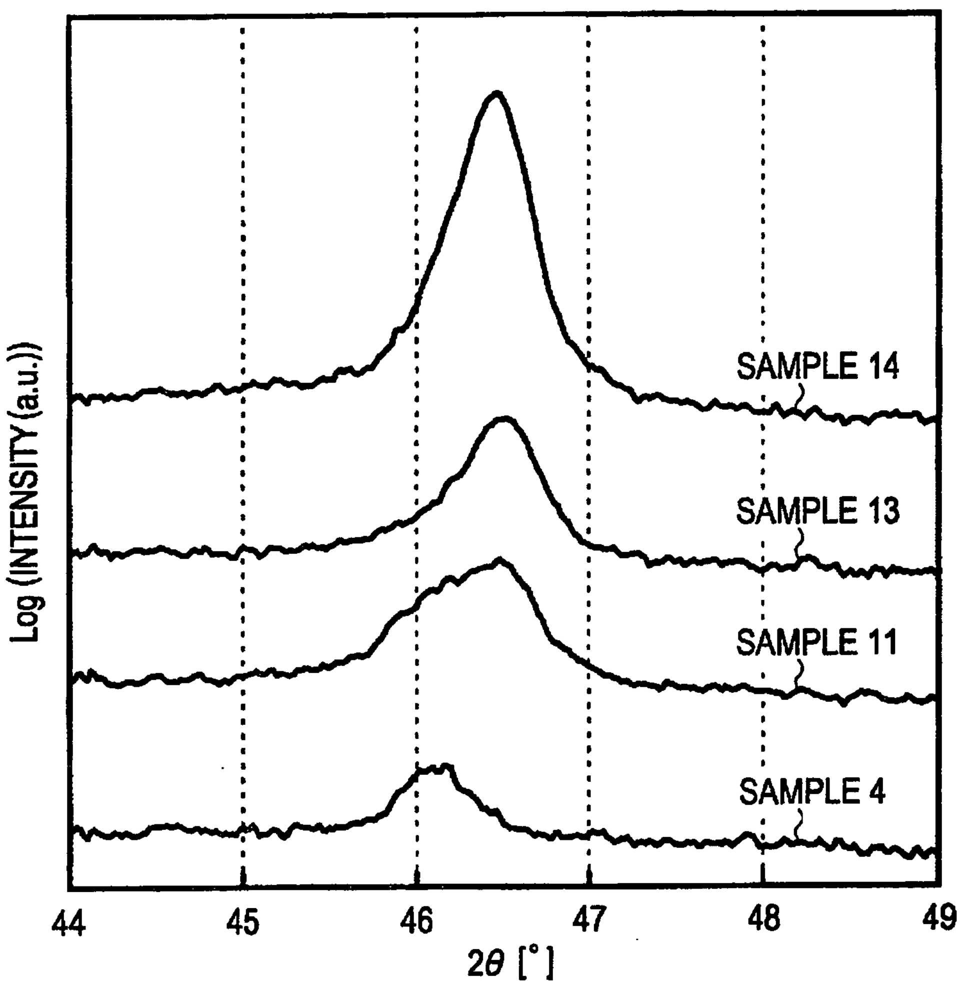
Log (INTENSITY (a.u.))
SAMPLE 14
SAMPLE 13
SAMPLE 11
SAMPLE 4
44
45
46
47
48
49
2θ [°]

FIG. 10A

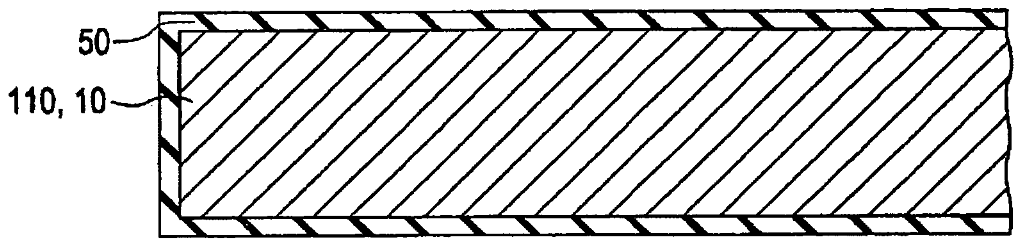


FIG. 10B

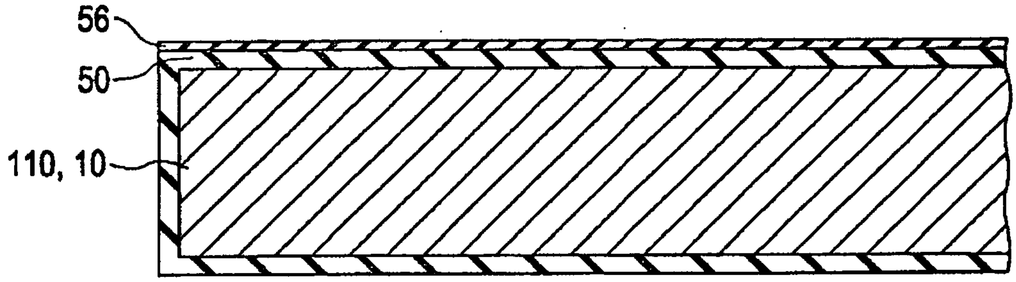

FIG. 11A

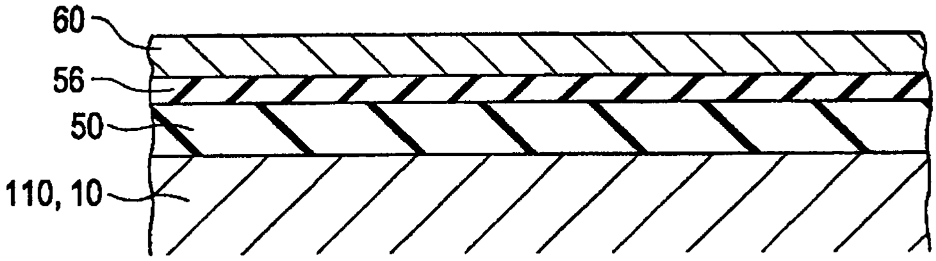


FIG. 11B

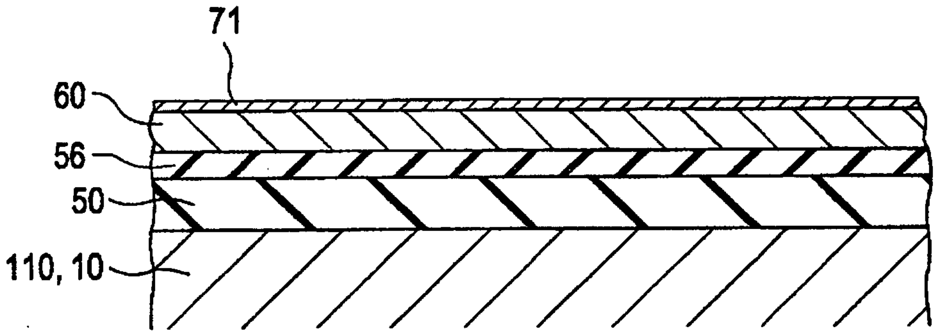


FIG. 11C

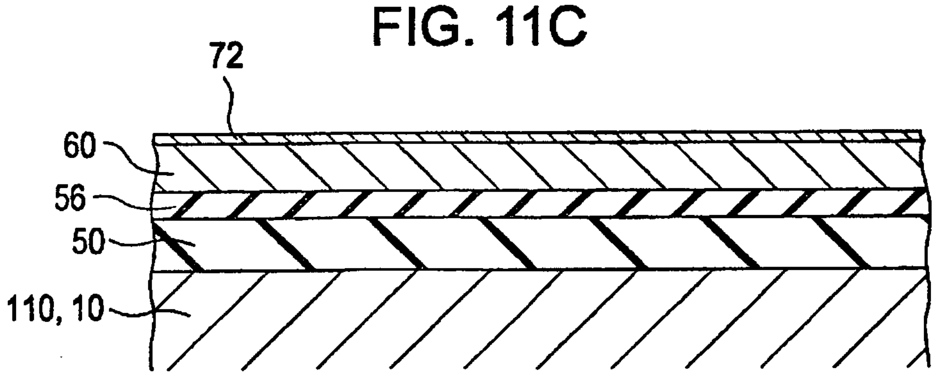

FIG. 12A

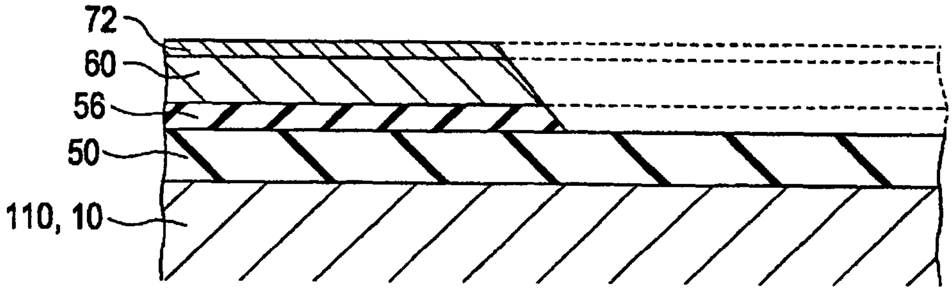


FIG. 12B

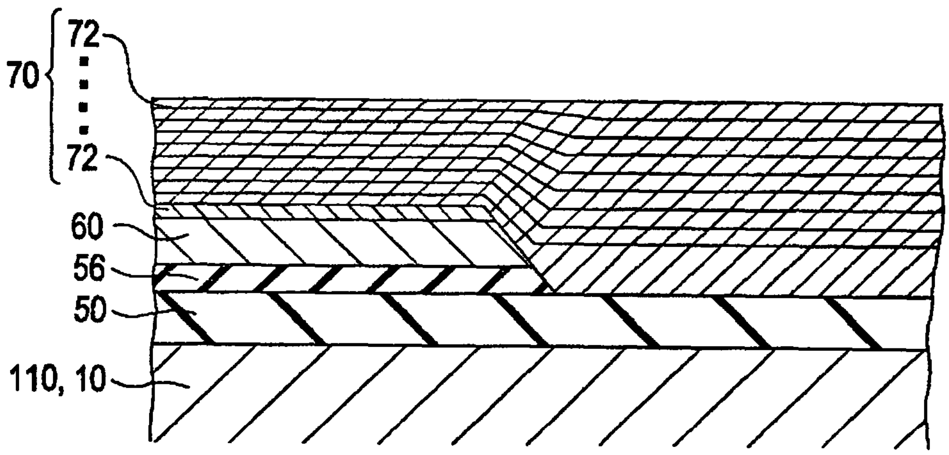

FIG. 13A

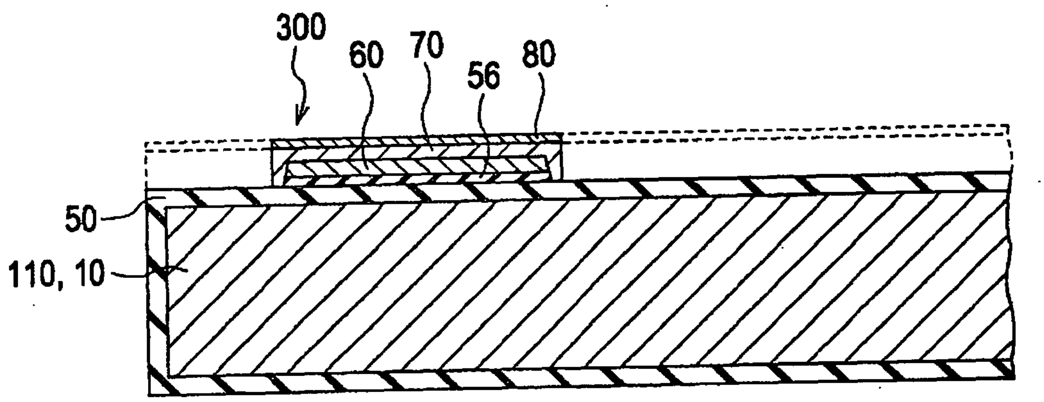


FIG. 13B

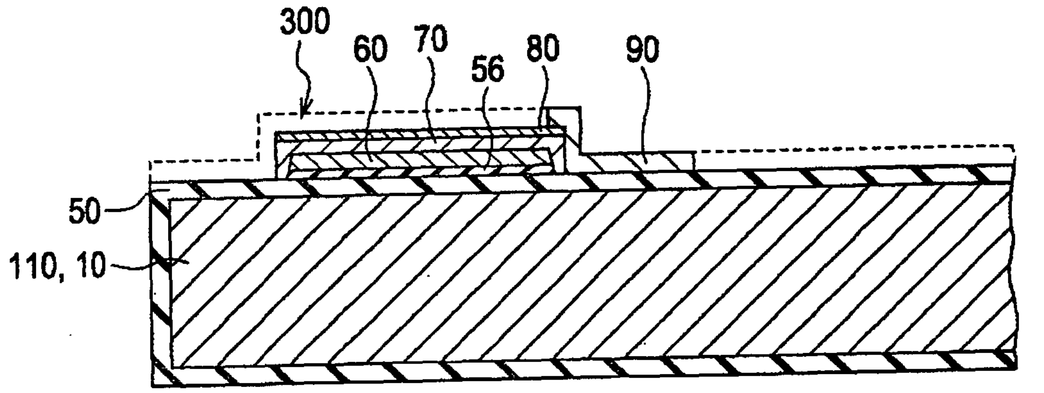


FIG. 13C

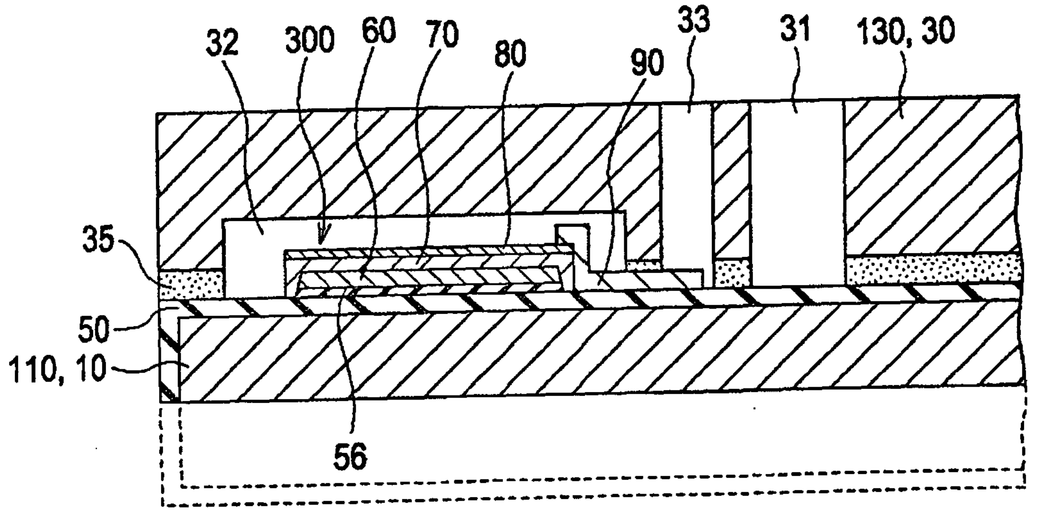

FIG. 14A

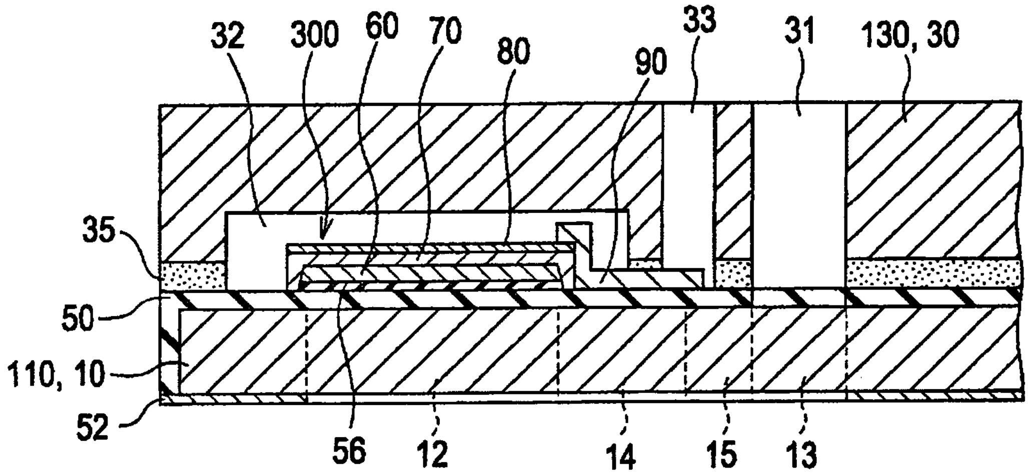


FIG. 14B

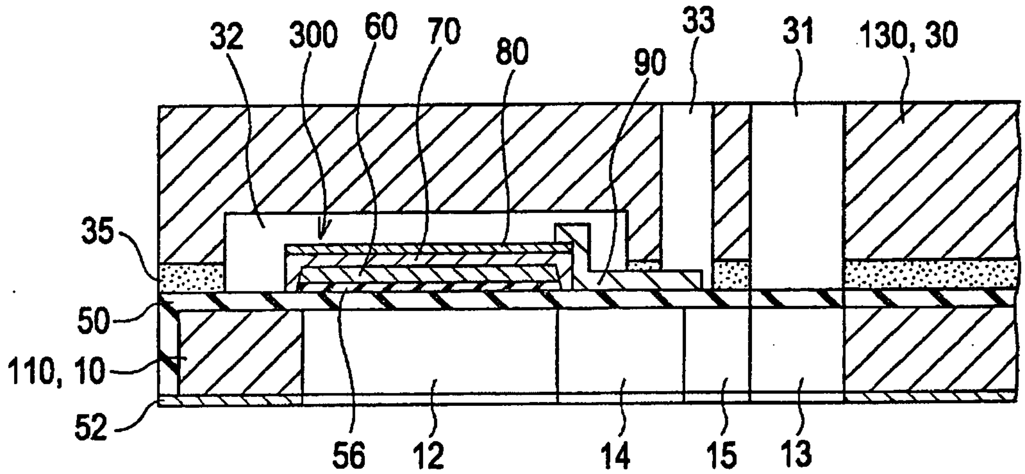

FIG. 15

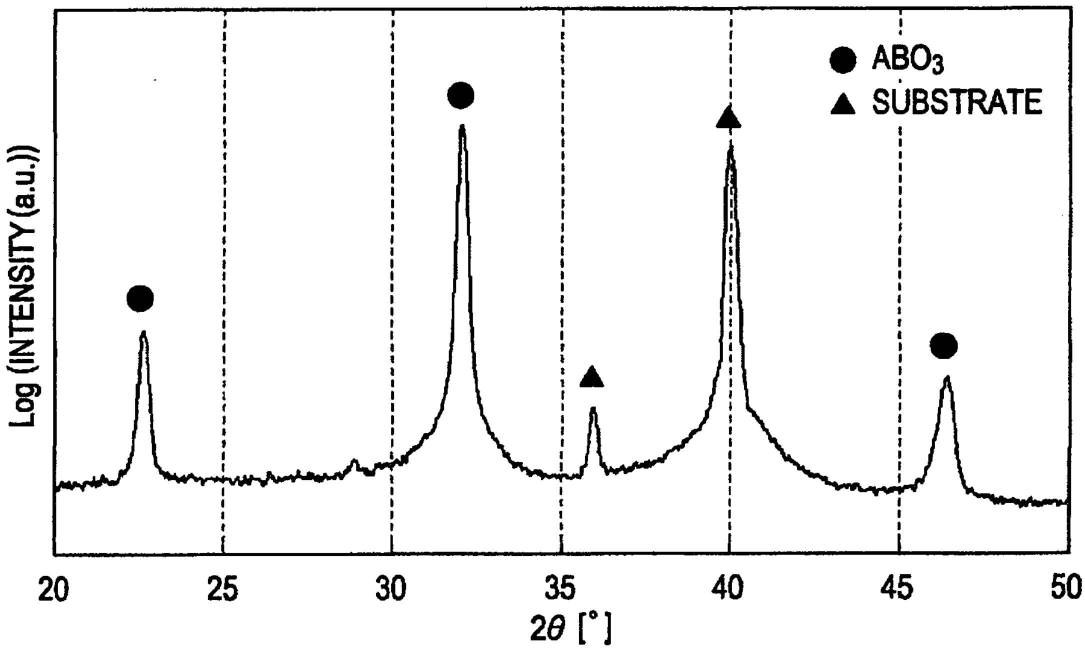

FIG. 16A

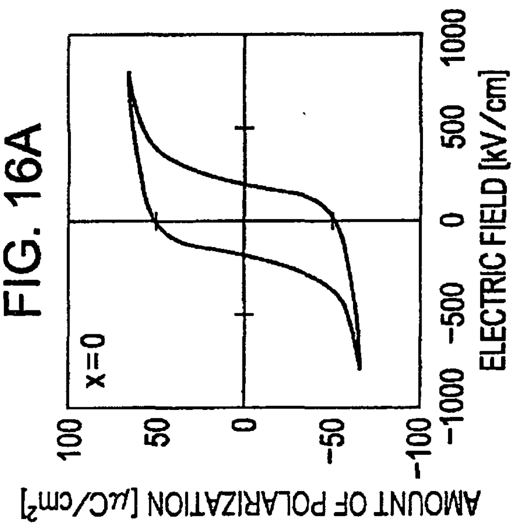


FIG. 16B

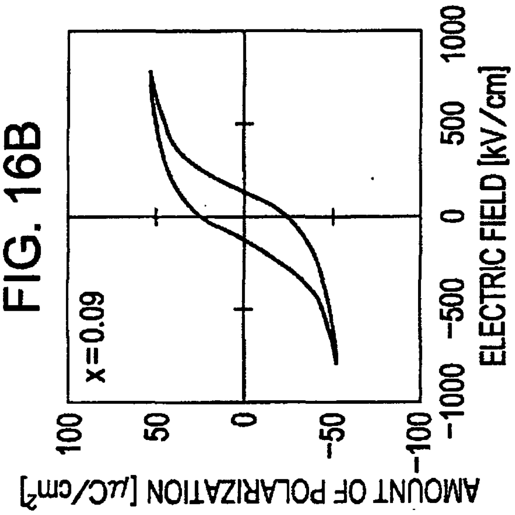


FIG. 16C

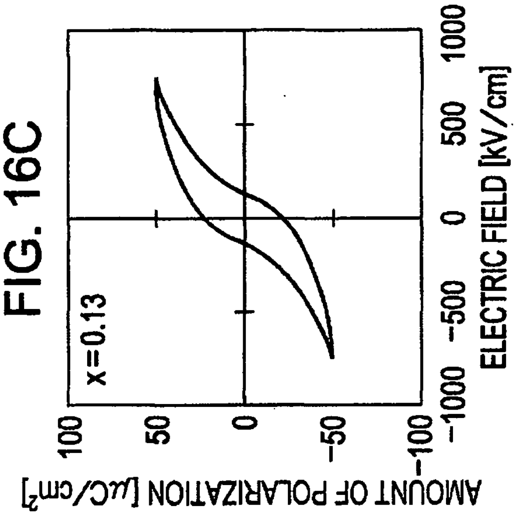


FIG. 16D

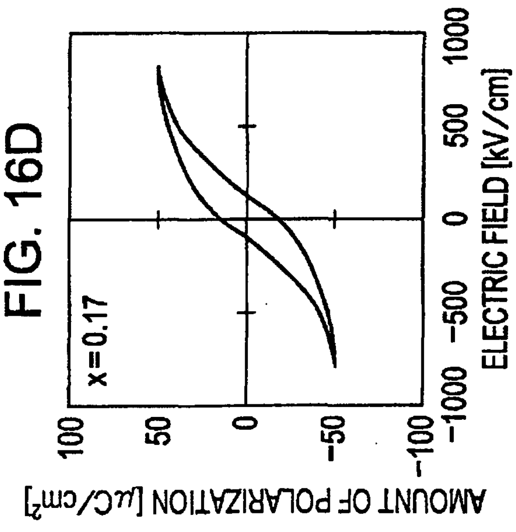


FIG. 16E

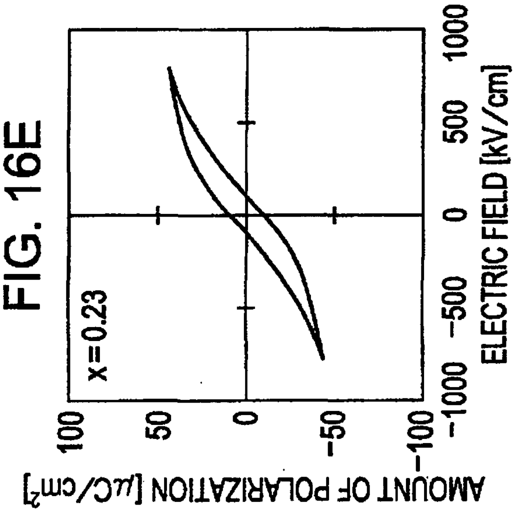


FIG. 16F

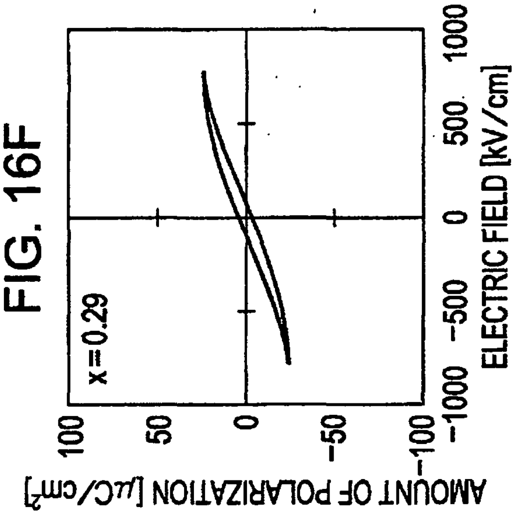

FIG. 17A

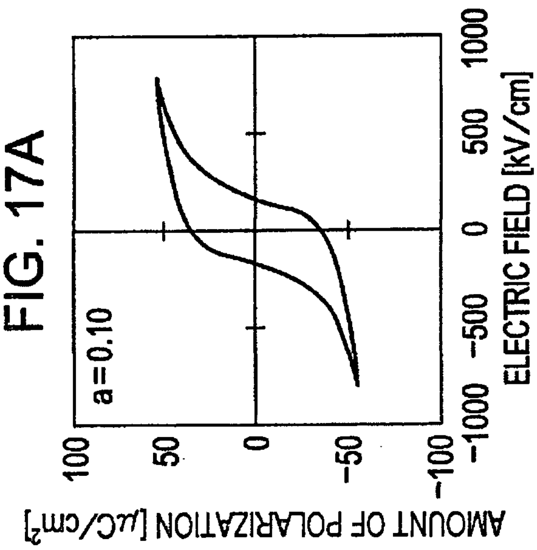


FIG. 17B

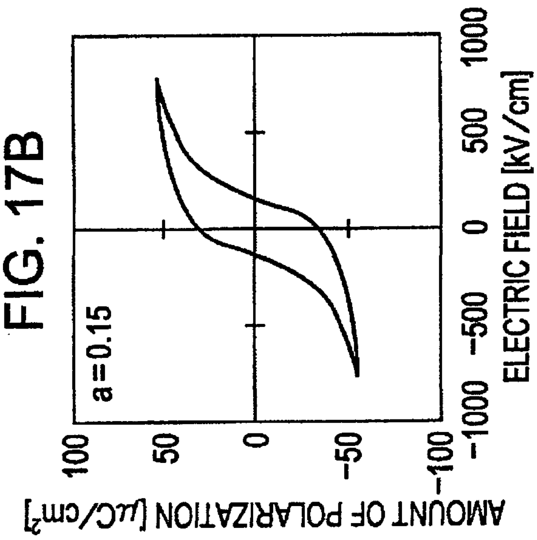


FIG. 17C

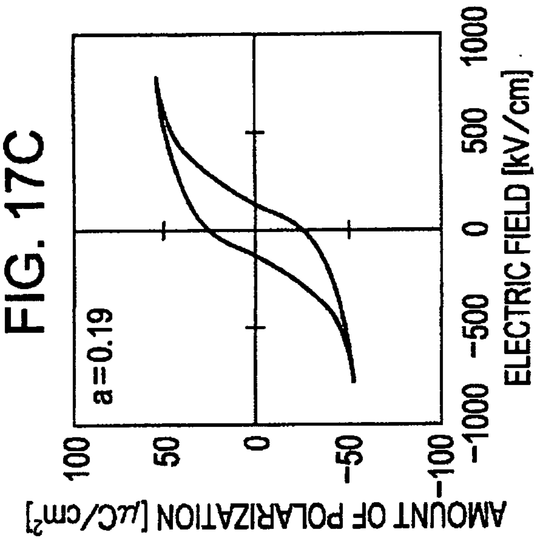


FIG. 17D

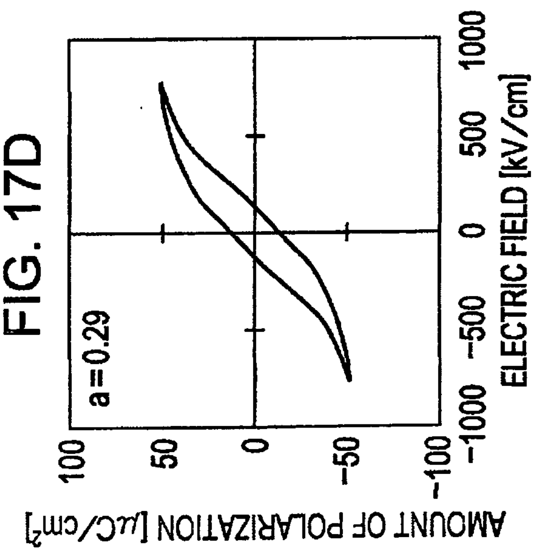


FIG. 17E

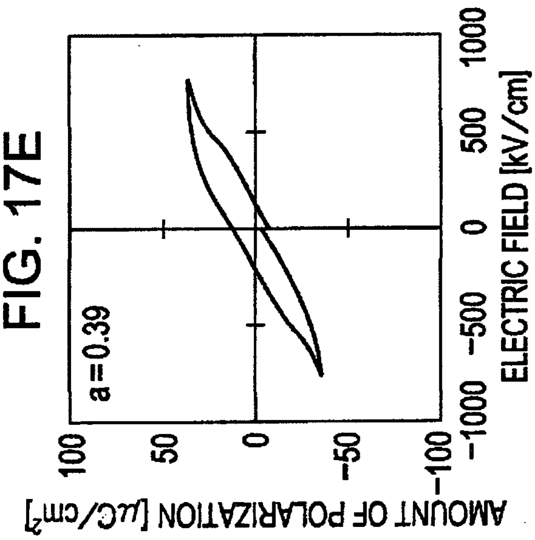

FIG. 18

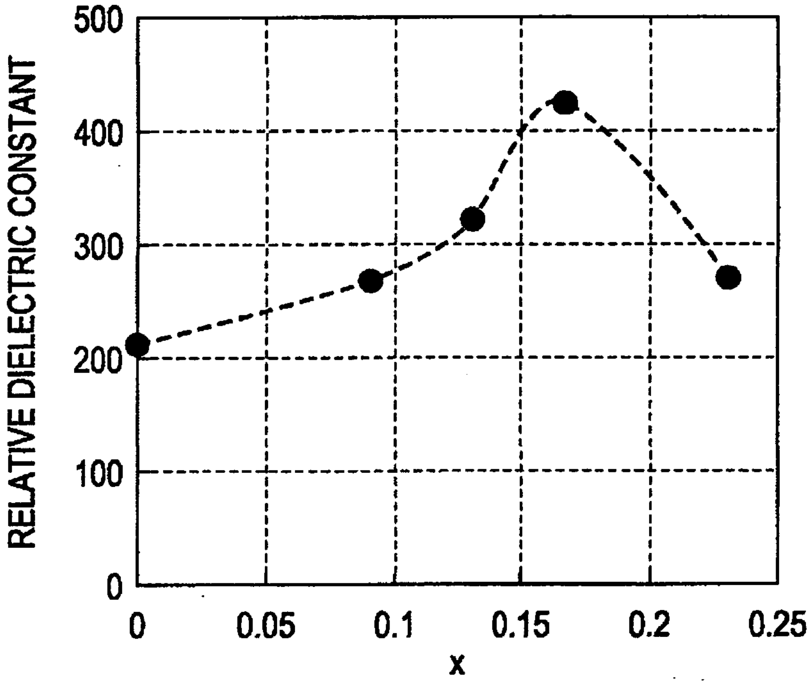
RELATIVE DIELECTRIC CONSTANT
500
400
300
200
100
0
0
0.05
0.1
0.15
0.2
0.25
x

FIG. 19

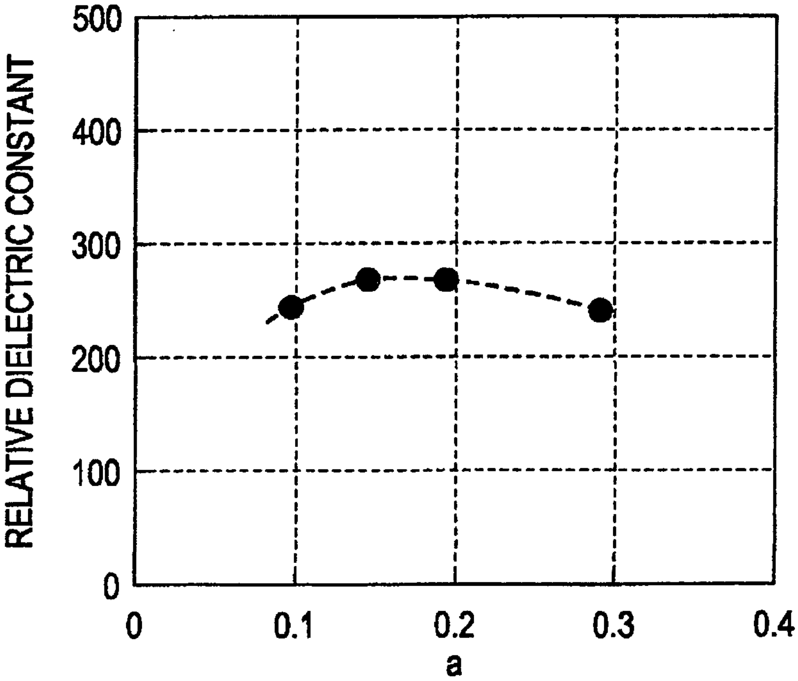
RELATIVE DIELECTRIC CONSTANT
500
400
300
200
100
0
0
0.1
0.2
0.3
0.4
a

FIG. 20

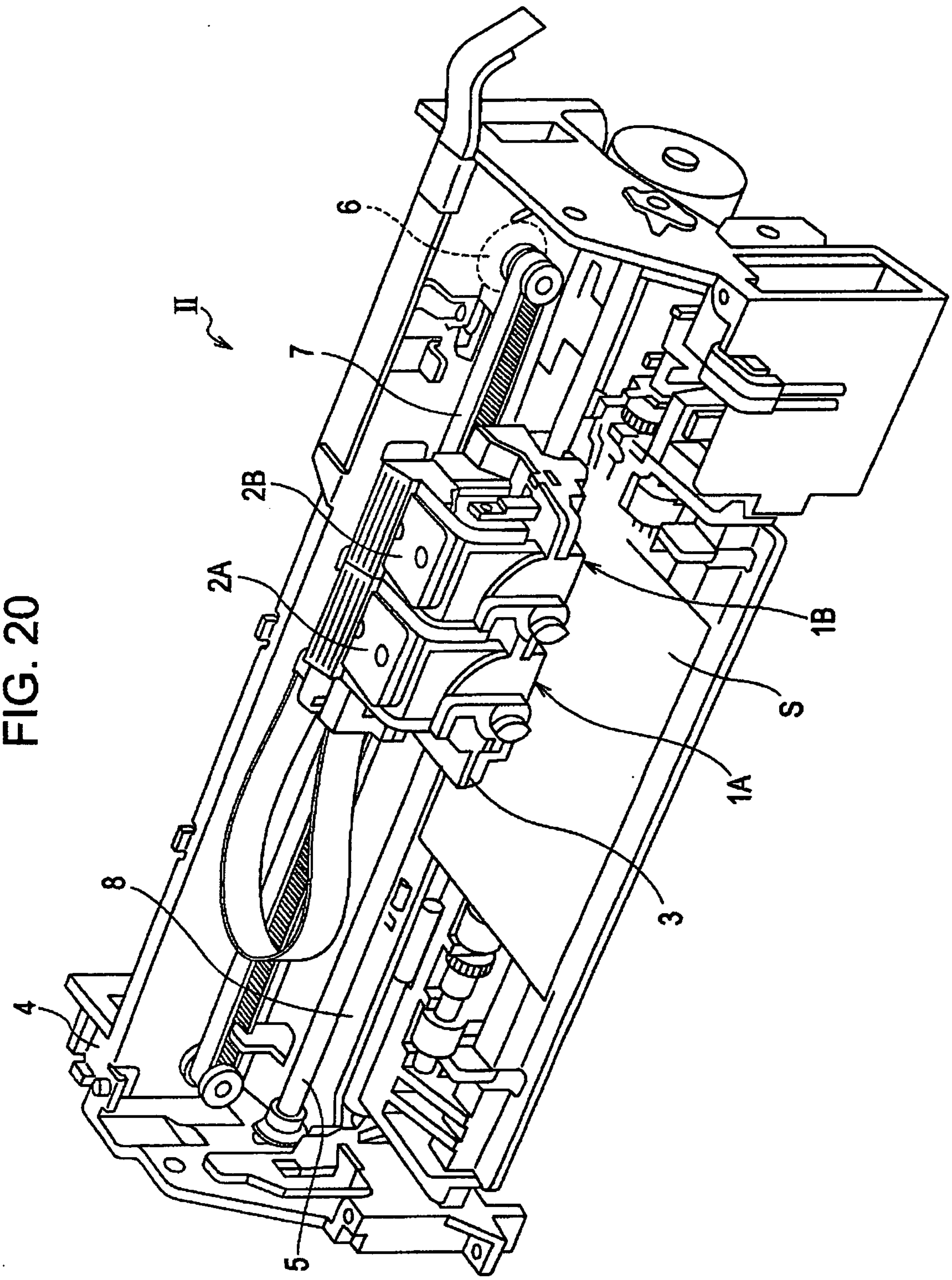

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001223404 A
- EP 2145975 A